# EUROPEAN PATENT SPECIFICATION

(11) **EP 2 896 324 B1**
(45) Date of publication and mention of the grant of the patent: **16.11.2016**
(21) Application number: 14151723.5
(22) Date of filing: 20.01.2014
(51) Int. Cl.: A47B 88/04, H05K 7/14, H05K 7/18

(54) **A rack comprising a slide assembly and a chassis**
Gestell umfassend eine Schiebeanordnung und ein Gehäuse
Support comprenant un assemblage de glissière et un châssis

(43) Date of publication of application: 22.07.2015
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Huang, Chien-Li, Kaohsiung City (TW); Wang, Chun-Chiang, Kaohsiung City (TW)
(74) Representative: Viering, Jentschura & Partner mbB Patent- und Rechtsanwälte

(56) References cited:
- DE-U1-202004 018 376
- US-A1- 2001 040 203
- US-A1- 2004 079 712
- US-A1- 2011 233 355
- US-A1- 2011 290 746

## Description

### FIELD OF THE INVENTION

The present invention relates to a rack with a slide assembly and a chassis, wherein the slide assembly is used to install a chassis to the rack.

### BACKGROUND OF THE INVENTION

US Patent No. 8,371,454 has disclosed a conventional rack system, which comprises a bracket assembly for installing a chassis to a rack, and is incorporated herein by reference.

The rack of the conventional rack system has a plurality of holes, and the bracket assembly of the conventional rack system has a bracket, a base and a fastening member, wherein the bracket has a plurality of bracket holes. The base is securely connected to the bracket and has multiple connection members located corresponding to the bracket holes. The fastening member is pivotally connected to the bracket and includes a resilient leg and a fastening arm which has at least one fastening portion. One of the connection members of the base is inserted into one of the holes of the rack, and the fastening portion of the fastening arm is hooked to the rack. However, the conventional rack system lacks of a mechanism for installing the chassis to the rack, such that the chassis may slip off from the rack easily to damage the equipment or cause injury.

The present invention intends to provide a rack with a slide assembly and a chassis wherein said slide assembly is able to secure the chassis in the rack.

### SUMMARY OF THE INVENTION

The present invention relates to a rack with a slide assembly for installing a chassis to a rack and a chassis, wherein the rack has a first post and a second post, and the first and second posts each have a plurality of holes. The chassis has a hook portion. The slide assembly comprises a first rail having a first end and a second end which is located corresponding to the first end. The first rail defines a first slide path longitudinally therein. A second rail is slidable relative to the first slide path of the first rail. A first bracket has a first end connected adjacent to the first end of the first rail and a second end connected to the first post of the rack. A second bracket has a first end connected adjacent to the second end of the first rail and a second end connected to the second post of the rack. The first bracket has a bracket board which has a first portion and a second portion. The second portion bends and extends from an end of the first portion. An engaging member is pivotally connected to the bracket board and has a body portion, a first fastening portion and a second fastening portion. The first and second fastening portions are substantially and perpendicularly connected to an end of the body portion. The second fastening portion bends and extends from an end of the first fastening portion. An engaging space is bounded by the first post and the second fastening portion when the second end of the first bracket is connected to the first post of the rack. A resilient member provides a force to the engaging member to maintain the first fastening portion to be connected to the first post of the rack, wherein the hook portion of the chassis is inserted into the engaging space bounded between the first post and the second fastening portion, and contacts the second fastening portion, such that when the chassis is located in the rack, the chassis is not pulled out from the rack.

The invention is defined by independent claim 1. Preferred embodiments are defined by the dependent claims.

Preferably, a third rail is slidably connected between the first and second rails to form a three-stage slide assembly.

Preferably, a back board is fixed adjacent to the first end of the first rail. The back board defines a second slide path longitudinally therein. The bracket board of the first bracket is movably received by the second slide path of the back board such that the first bracket is longitudinally movable along the back board.

Preferably, the first bracket has at least one projecting member which is connected to the second portion of the bracket board. The at least one projecting member is inserted into one of the holes of the first post.

Preferably, the engaging member comprises an operation portion which is connected to the body portion. The bracket board has a slot which is located between the first and second portions thereof. When the operation portion of the engaging member is operated, the slot accommodates the operation portion.

The present invention also provides a rack with a slide assembly which comprises a first rail, a second rail and a third rail. The first rail has a first end and a second end which is located corresponding to the first end. The third rail is slidably connected between the first and second rails. A first bracket is connected adjacent to the first end of the first rail. A second bracket is connected adjacent to the second end of the first rail. The first bracket has a bracket board which has a first portion and a second portion. The second portion bends and extends from an end of the first portion. At least one projecting member is connected to the second portion of the bracket board. An engaging member is pivotally connected to the bracket board and has a body portion, a first fastening portion and a second fastening portion. The first and second fastening portions are substantially and perpendicularly connected to an end of the body portion. The second fastening portion bends and extends from an end of the first fastening portion. A resilient member provides a force to the engaging member to maintain the first fastening portion to be positioned close to the at least one projecting member.

Preferably, a back board is fixed to the first rail. The bracket board is movably connected to the back board so that the first bracket is longitudinally movable along the back board.

Preferably, the engaging member comprises an operation portion which is connected to the body portion. The bracket board has a slot which is bounded by the first and second portions of the bracket board. When the operation portion of the engaging member is operated, the slot accommodates the operation portion.

The present invention will become more obvious from the following description when taken in connection with the accompanying drawings which show, for purposes of illustration only, a preferred embodiment in accordance with the present invention.

### BRIEF DESCRIPTION OF THE DRAWINGS

FIG. 1 is a perspective view of a rack with a slide assembly wherein the slide assembly is installed to a rack;
FIG. 2 is an exploded view of the slide assembly;
FIG. 3 is an enlarged view to show a portion of the bracket board of the slide assembly;
FIG. 4A is an enlarged view to show a portion of the slide assembly in FIG.1;
FIG. 4B is another enlarged view to show a portion of the slide assembly in FIG.1;
FIG. 5A shows the operation step for installing a first bracket of the slide assembly to a first post of the rack;
FIG. 5B shows another operation step for installing the first bracket of the slide assembly to the first post of the rack;
FIG. 5C shows yet another operation step for installing the first bracket of the slide assembly to the first post of the rack;
FIG.6 is a top view of the rack with the slide assembly and the rack in accordance with the preferred embodiment of the present invention, wherein the slide assembly is installed to the rack and a chassis is received by the rack;
FIG. 7 is a side view of the slide assembly in FIG. 6; and
FIG. 8 is a side view to show the operation step for removing the chassis from the rack.

### DETAILED DESCRIPTION OF THE PREFERRED EMBODIMENT

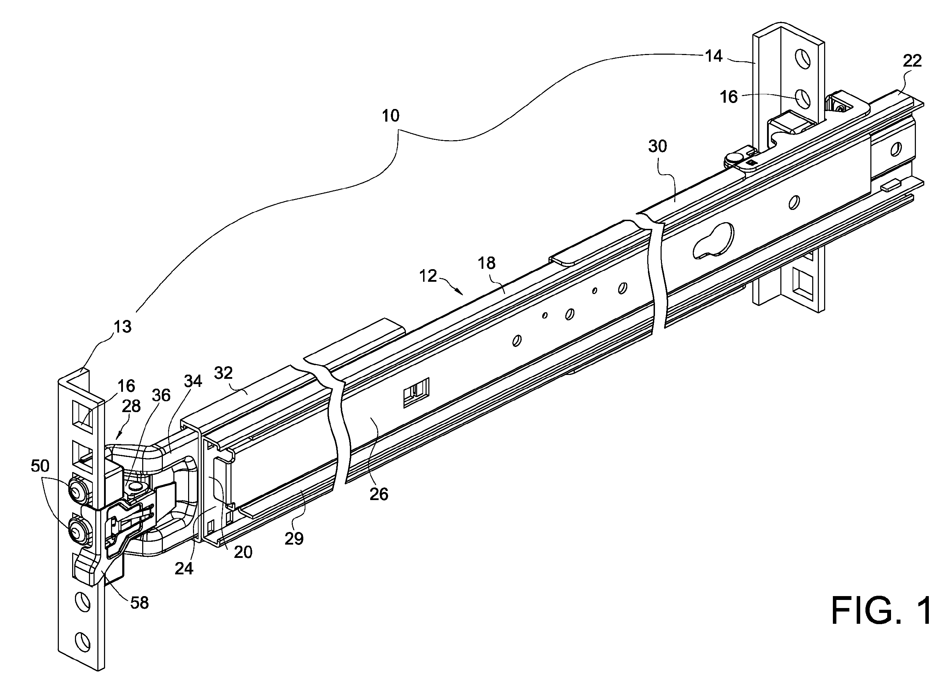

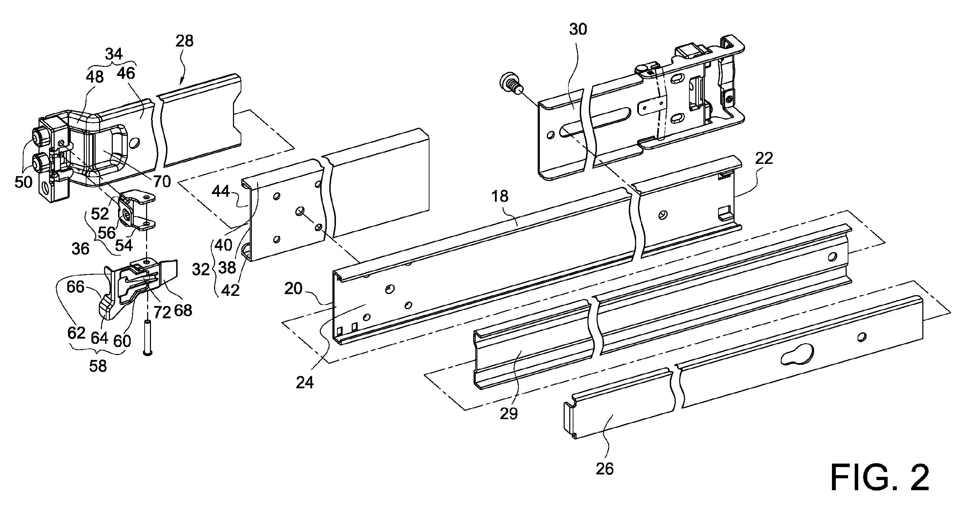

Referring to FIGS. 1 and 2, rack 10 and a slide assembly 12 are shown. The slide assembly 12 is used to install a chassis to the rack 10. The rack 10 at least comprises a first post 13 and a second post 14, wherein the first and second posts 13, 14 each have a plurality of holes 16. The slide assembly 12 is connected between the first and second posts 13, 14. The slide assembly 12 comprises a first rail 18, a second rail 26, a first bracket 28 and a second bracket 30.

The first rail 18 has a first end 20 and a second end 22 which is located corresponding to the first end 20. The first rail 18 defines a first slide path 24 longitudinally therein. The second rail 26 is slidable relative to the first slide path 24 of the first rail 18. Preferably, a third rail 29 is slidably connected between the first and second rails 18, 26 to form a three-stage slide assembly to extend the length of the slide assembly 12.

One end of the first bracket 28 is connected adjacent to the first end 20 of the first rail 18, and the other end of the first bracket 28 is adapted to be connected to the first post 13 of the rack 10. One end of the second bracket 30 is connected adjacent to the second end 22 of the first rail 18, and the other end of the second bracket 30 is adapted to be connected to the second post 14 of the rack 10.

The first bracket 28 comprises a bracket board 34, a connecting member 36, at least one projecting member 50 and an engaging member 58. Preferably, the slide assembly 12 further has a back board 32. The back board 32 is connected to the first rail 18 such that the first bracket 28 can be connected to the first rail 18 by the back board 32. In one embodiment, the back board 32 is fixedly connected adjacent to the first end 20 of the first rail 18 and has a top wall 40, a bottom wall 42 and a side wall 38. The side wall 38 extends between the top and bottom walls 40, 42 such that a second slide path 44 is bounded by the top wall 40, the bottom wall 42 and the side wall 38, and the bracket board 34 of the first bracket 28 is movably connected to the back board 32 so that the first bracket 28 can move longitudinally along the back board 32.

In more detail, the bracket board 34 has a first portion 46 and a second portion 48, wherein the second portion 48 bends and extends from one end of the first portion 46. In this embodiment, the first portion 46 of the bracket board 34 is received by the second slide path 44 of the back board 32 such that the first bracket 28 is longitudinally movable along the back board 32. The connecting member 36 has a riveting portion 52, a pivoting portion 54 and a contact portion 56, wherein the connecting member 36 is fixedly connected to the second portion 48 of the bracket board 34 by the riveting portion 52 thereof.

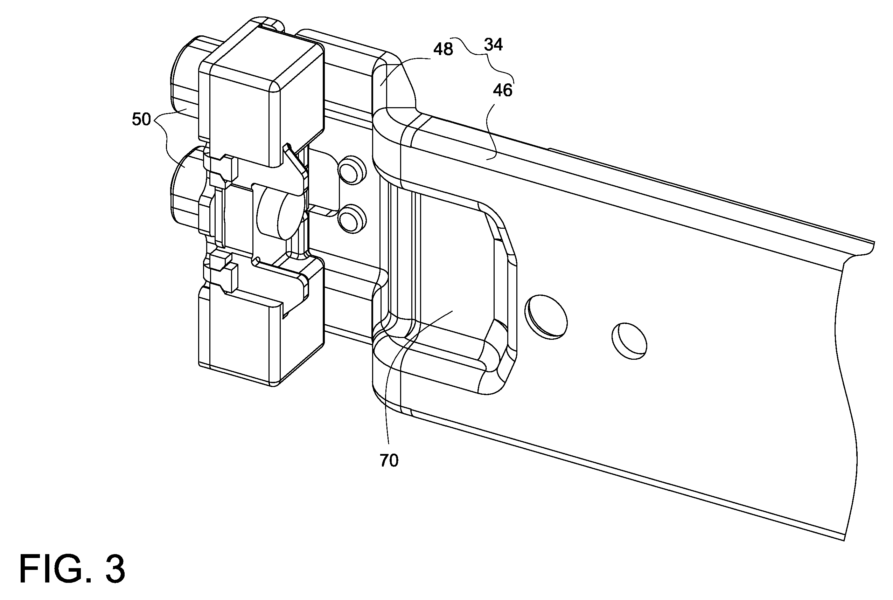

Referring to FIG. 3, the at least one projecting member 50 of the firs bracket 28 is longitudinally connected to the second portion 48 of the bracket board 34, such that the bracket board 34 is able to connect one end of the slide assembly 12 to the first post 13 by insertion of the at least one projecting member 50 into one of the holes 16 of the first post 13. Preferably, the second bracket 30 also has at least one projecting member 50 which is adapted to be inserted into one of the holes 16 of the second post 14 to connect the other end of the slide assembly 12 to the second post 14.

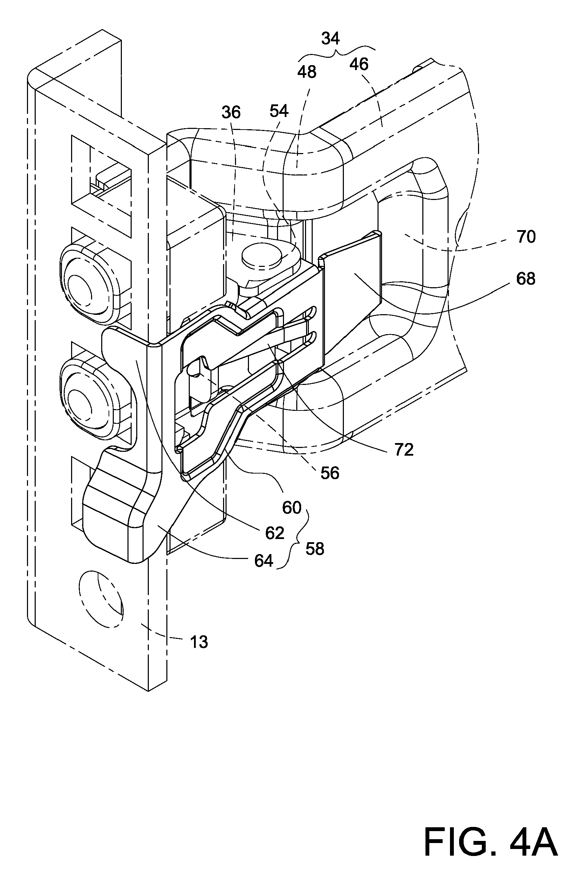

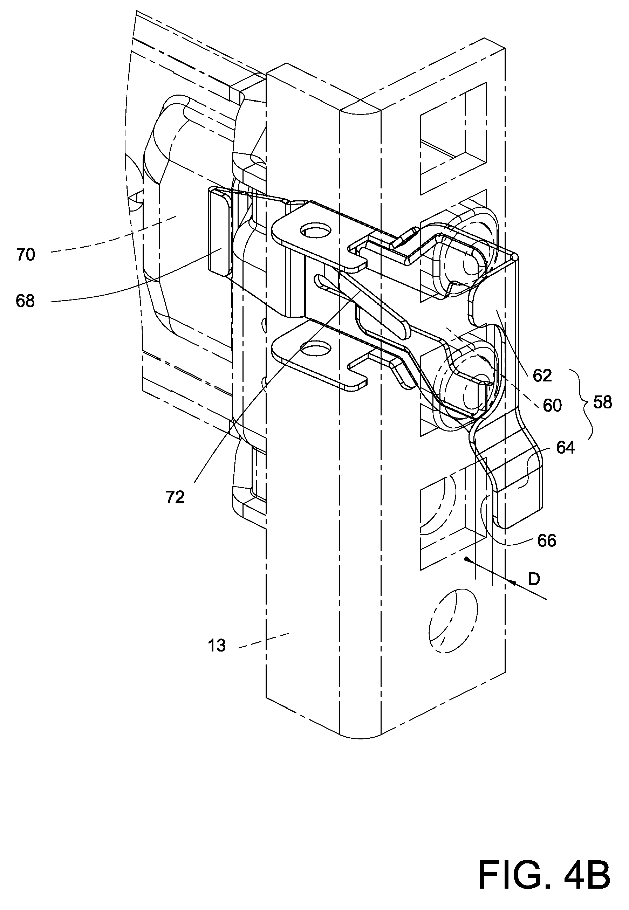

Referring to FIGS. 4A and 4B, the engaging member 58 can be pivotally connected to a position close to the second portion 48 of the bracket board 34, such as, be pivotally connected to the pivoting portion 54 of the connecting member 36. The engaging member 58 comprises a body portion 60, a first fastening portion 62 and a second fastening portion 64, wherein the first and second fastening portions 62, 64 are substantially and perpendicularly connected to one end of the body portion 60, and the second fastening portion 64 bends and extends from one end of the first fastening portion 62, whereby when the first bracket 28 is connected to the first post 13, the first fastening portion 62 contacts the first post 13, and an engaging space 66 is bounded by the first post 13 and the second fastening portion 64. The engaging space 66 has a width "D".

The engaging member 58 further comprises an operation portion 68 which is connected to the body portion 60, and the bracket board 34 has a slot 70 which is bounded by the first and second portions 46, 48 of the bracket board 34. When the operation portion 68 of the engaging member 58 is operated, such as being pressed, the slot 70 can accommodate the operation portion 68.

Preferably, the first bracket 28 further comprises a resilient member 72, wherein one end of the resilient member 72 is connected to the engaging member 58, and the other end of the resilient member 72 contacts against the contact portion 56 of the connecting member 36. The resilient member 72 provides a force to the engaging member 58 to maintain the first fastening portion 62 to be positioned close to the at least one projecting member 50 and to be securely connected to the first post 13.

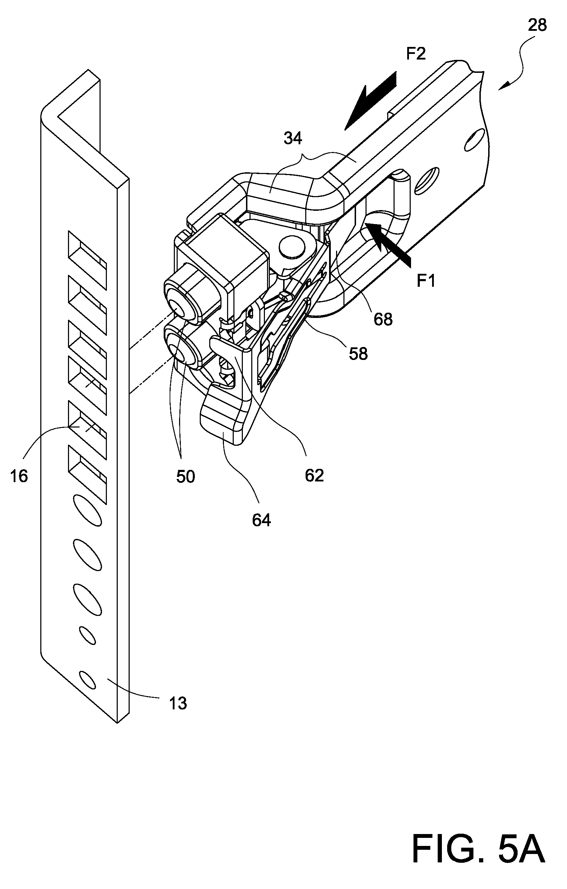

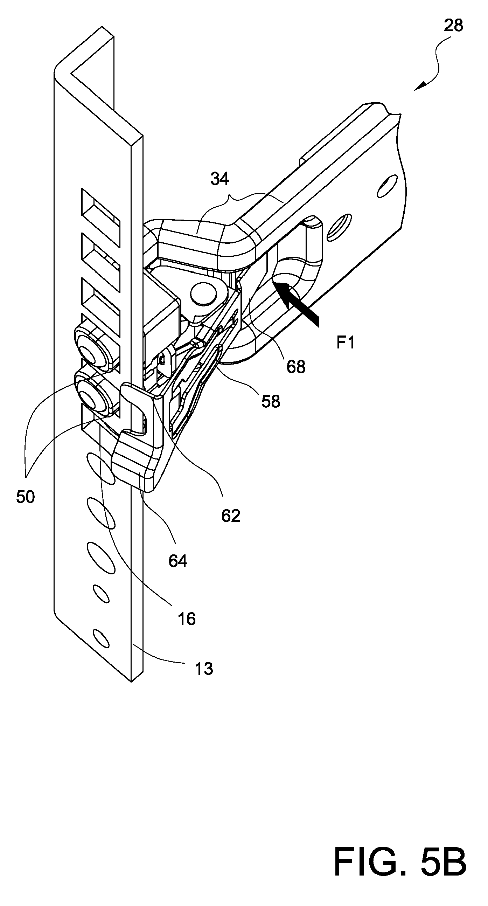

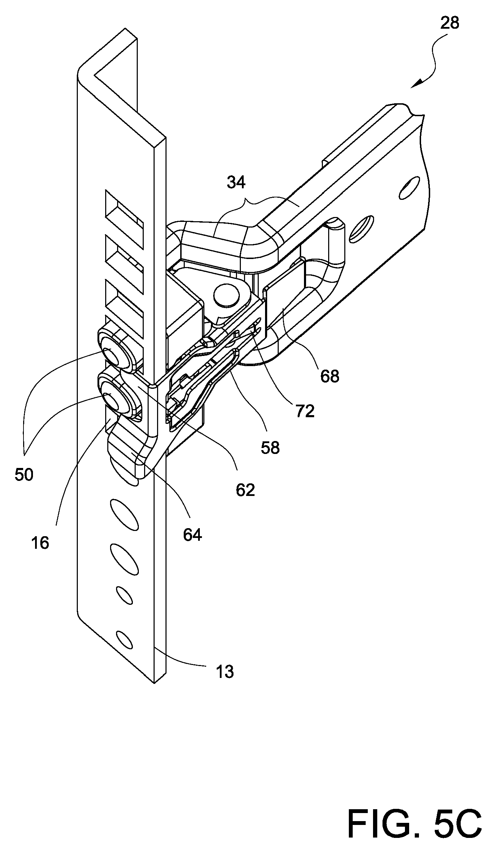

FIGS. 5A, 5B and 5C show the installation of the first bracket 28 to the first post 13 of the rack 10. A force F1 is applied to the operation portion 68 of the engaging member 58 to let the first and second fastening portions 62, 64 of the engaging member 58 be away from the at least one projecting member 50 for a distance, and a force F2 is applied to the bracket board 34 to insert the at least one projecting member 50 into one of the holes 16 of the first post 13 (as shown in FIG. 5B), and then the forces F1 and F2 are released at the same time (as shown in FIG. 5C) such that a force stored in the resilient member 72 is released to recover the first and second fastening portions 62, 64 of the engaging member 58 to a position which is close to the at least one projecting member 50. Therefore, the first fastening portion 62 is securely connected to the first post 13, and thus the first bracket 28 is positioned and installed to the first post 13.

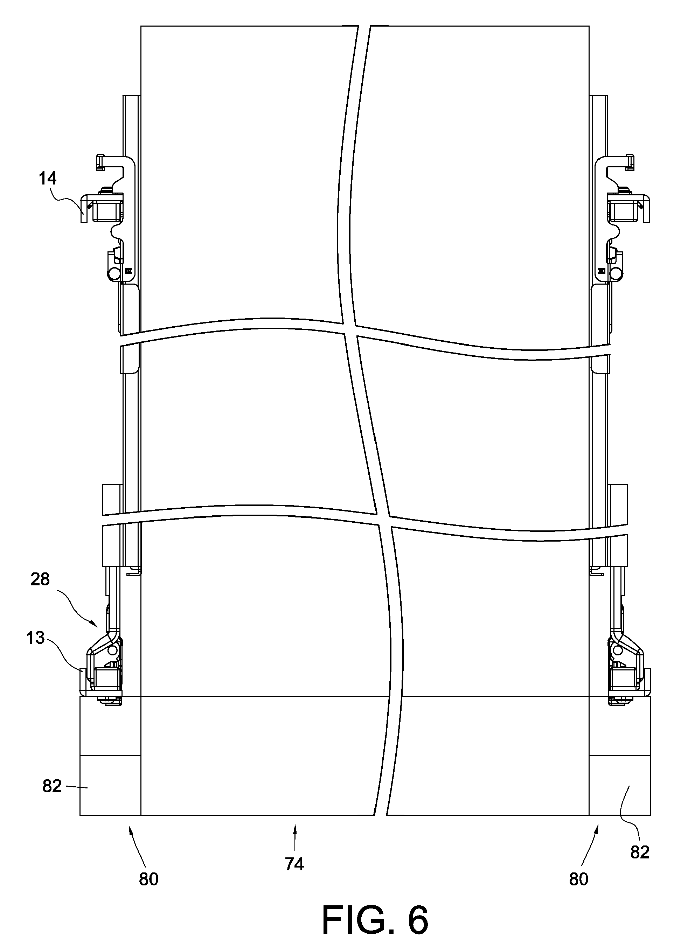

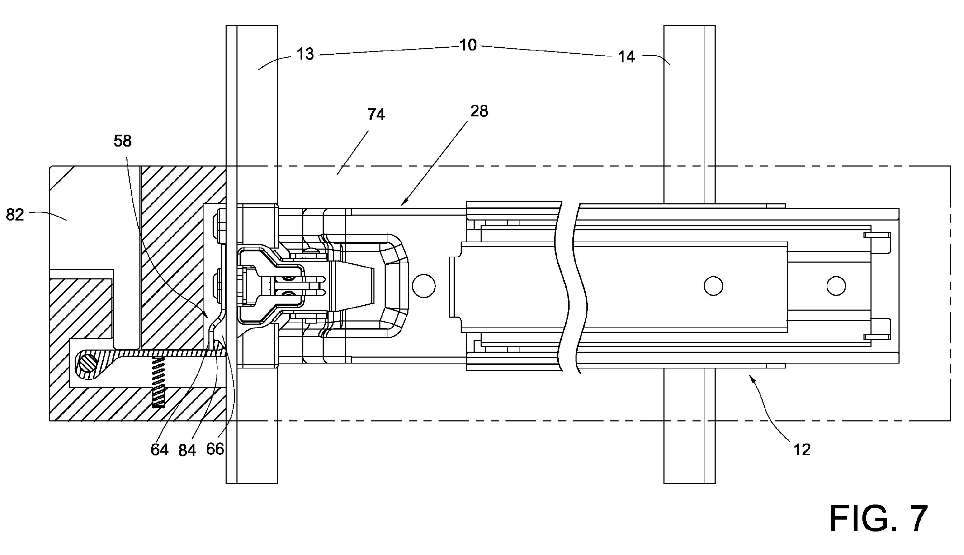

Referring to FIGS. 6 and 7, a chassis 74 has one side thereof connected to the slide assembly 12. Preferably, the chassis 74 has an engaging mechanism 80 which is located corresponding to the second fastening portion 64 of the engaging member 58 of the first bracket 28. The engaging mechanism 80 comprises a control portion 82 and a hook portion 84. When the chassis 74 together with the slide assembly 12 are received by the rack 10, the hook portion 84 is inserted into the engaging space 66 bounded by the first post 13 of the rack 10 and the second fastening portion 64 of the engaging member 58 to contact the second fastening portion 64 of the engaging member 58, such that the hook portion 84 is retained in the engaging space 66. Therefore, the chassis 74 is positioned and prevented from being pulled out from the rack 10 easily.

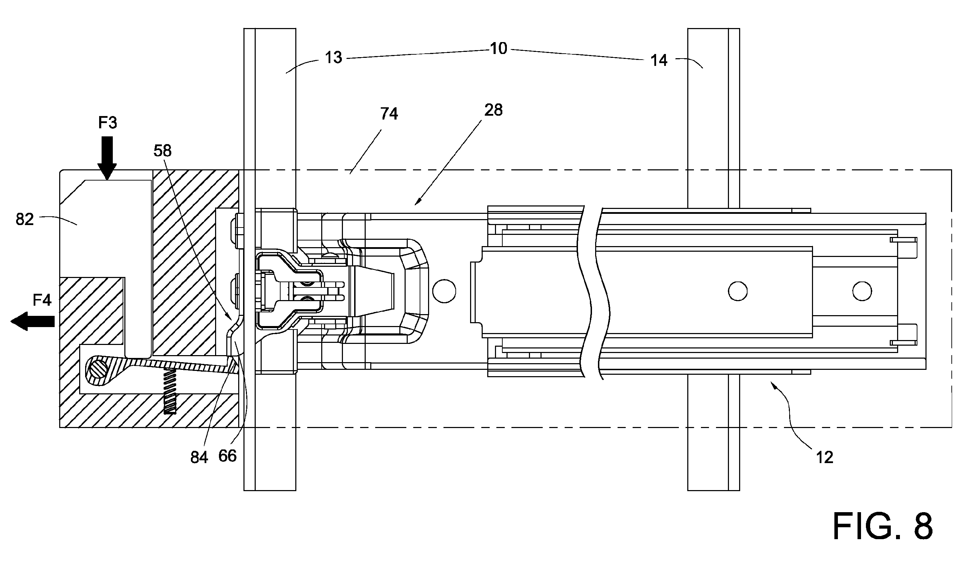

Referring to FIG. 8, when a force F3 is applied to the control portion 82 to press the hook portion 84 out of the engaging space 66, the chassis 74 can be pulled out from the rack 10 as a force F4 is further applied to the chassis 74.

While we have shown and described the embodiment in accordance with the present invention, it should be clear to those skilled in the art that further embodiments may be made without departing from the scope of the present invention.

## Claims

1. A rack (10) comprising a slide assembly (12) and a chassis (74) wherein the slide assembly comprises:
a first rail (18) having a first end (20) and a second end (22) which is located corresponding to the first end (20);
a second rail (26);
a first bracket (28) connected adjacent to the first end (20) of the first rail (18); and
a second bracket (30) connected adjacent to the second end (22) of the first rail (18), the first bracket (28) includes:
a bracket board (34) having a first portion (46) and a second portion (48), the second portion (48) bending and extending from an end of the first portion (46);
at least one projecting member (50) connected to the second portion (48) of the bracket board (34);
an engaging member (58) connected to the bracket board (34) and having a body portion (60), a first fastening portion (62) and a second fastening portion (64), and
a resilient member (72) for providing a force to the engaging member (58) to maintain the first fastening portion (62) to be positioned close to the at least one projecting member (50), **characterized in that** the engaging member (58) is pivotally connected to the bracket board (34) and the first and second fastening portions (62, 64) are substantially and perpendicularly connected to an end of the body portion (60), the second fastening portion (64) bending and extending from an end of the first fastening portion (62),
wherein the slide assembly is adapted for installing the chassis (74) to the rack (10), the rack (10) has a first post (13) and a second post (14), the first and second posts (13, 14) each have a plurality of holes (16), and the chassis (74) has a hook portion (84), and
wherein the first rail (18) defines a first slide path (24) longitudinally therein, and the second rail (26) is slidable relative to the first slide path (24) of the first rail (18);
a first end of the first bracket (28) is connected adjacent to the first end (20) of the first rail (18), a second end of the first bracket (28) is adapted to be connected to the first post (13) of the rack (10);
a first end of the second bracket (30) is connected adjacent to the second end (22) of the first rail (18), a second end of the second bracket (30) is adapted to be connected to the second post (14) of the rack (10);
an engaging space (66) is bounded by the first post (13) and the second fastening portion (64) when the second end of the first bracket (28) is connected to the first post (13) of the rack (10);
the first fastening portion (62) of the engaging member (58) is adapted to be connected to the first post (13) of the rack (10) by the force provided by the resilient member (72);
and wherein the hook portion (84) of the chassis (74) is adapted to be inserted into the engaging space (66) bounded by the first post (13) of the rack (10) and the second fastening portion (64) of the engaging member (58) to contact against the second fastening portion (64), whereby the chassis (74) is prevented from being pulled out from the rack (10) when being installed to the rack (10).

2. The rack (10) as claimed in claim 1, the slide assembly (12) further comprising a back board (32) fixed to the first rail (18), wherein the bracket board (34) is movably connected to the back board (32) so that the first bracket (28) is longitudinally movable along the back board (32).

3. The rack (10) as claimed in claim 1, the slide assembly (12) further comprising a third rail (29) slidably connected between the first and second rails (18, 26) to form a three-stage slide assembly.

4. The rack (10) as claimed in claim 1, the slide assembly (12) further comprising a back board (32) fixed adjacent to the first end (20) of the first rail (18), wherein the back board (32) defines a second slide path (44) longitudinally therein, and the bracket board (34) of the first bracket (28) is movably received by the second slide path (44) of the back board (32) such that the first bracket (28) is longitudinally movable along the back board (32).

5. The rack (10) as claimed in claim 1, wherein the at least one projecting member (50) is adapted to be inserted into one of the holes (16) of the first post (13).

6. The rack (10) as claimed in claim 1, wherein the engaging member (58) comprises an operation portion (68) connected to the body portion (60), and the bracket board (34) has a slot (70) bounded by the first and second portions (46, 48) thereof so as to accommodate the operation portion (68) of the engaging member (58) by the slot (70) when the operation portion (68) is operated.

## Patentansprüche

1. Eine Zahnstange (10), umfassend einen Schlitten (12) und ein Fahrgestell (74), wobei der Schlitten die folgenden Elemente umfasst:
eine erste Schiene (18) mit einem ersten Endteil (20) und einem zweiten Endteil (22), der in Übereinstimmung mit dem ersten Endteil (20) gebildet ist;
eine zweite Schiene (26);
eine erste Halterung (28), die angrenzend am ersten Endteil (20) der ersten Schiene (18) befestigt ist; und
eine zweite Halterung (30), die angrenzend am zweiten Endteil (22) der ersten Schiene (18) befestigt ist, wobei die erste Halterung (28) aus den folgenden Komponenten besteht:
ein Rückplättchen (34) mit einem ersten Teil (46) und einem zweiten Teil (48), wobei der zweite Teil (48) gebogen ist und sich von einem Ende des ersten Teils (46) erstreckt;
mindestens einem vorstehenden Teil (50), der am zweiten Teil (48) des Rückplättchen (34) befestigt ist;
ein Einrastglied (58), das am Rückplättchen (34) befestigt ist und mit einem Gehäuseteil (60), einem ersten Befestigungsteil (62) und mit einem zweiten Befestigungsteil (64) gebildet ist, und
ein bewegliches Element (72) zum Ausüben einer Kraft auf das Einrastglied (58), um den ersten Befestigungsteil (62) nahe zum mindestens einen vorstehenden Teil (50) zu halten, **dadurch gekennzeichnet, dass** das Einrastglied (58) drehgelenkig am Rückplättchen (34) befestigt ist und der erste und zweite Befestigungsteil (62, 64) im Wesentlichen senkrecht an einem Ende des Gehäuseteils (60) befestigt sind; der zweite Befestigungsteil (64) gebogen ist und sich von einem Ende des ersten Befestigungsteils (62) erstreckt,
wobei mit dem Schlitten das Fahrgestell (74) an die Zahnstange (10) installiert wird; die Zahnstange (10) eine erste Stange (13) und eine zweite Stange (14) aufweist; die erste und zweite Stange (13, 14) je mehrere Löcher (16) aufweisen, während das Fahrgestell (74) mit einem Haken (84) gebildet ist, und
wobei die erste Schiene (18) der Länge nach einen ersten Schlittenweg (24) bildet, während die zweite Schiene (26) im ersten Schlittenweg (24) der ersten Schiene (18) gleitbar befestigt ist;
ein erster Endteil der ersten Halterung (28) agrenzend am ersten Endteil (20) der ersten Schiene (18) befestigt ist, während ein zweiter Endteil der ersten Halterung (28) an die erste Stange (13) der Zahnstange (10) befestigt werden kann;
ein erster Endteil der zweiten Halterung (30) angrenzend am zweiten Endteil (22) der ersten Schiene (18) befestigt ist, während ein zweiter Endteil der zweiten Halterung (30) an die zweite Stange (14) der Zahnstange (10) befestigt werden kann;
ein Einrastraum (66) durch die erste Stange (13) und durch den zweiten Befestigungsteil (64) begrenzt wird, wenn der zweite Endteil der ersten Halterung (28) an die erste Stange (13) der Zahnstange (10) befestigt wird;
der erste Befestigungsteil (62) des Einrastgliedes (58) mit der Kraft, die mit dem beweglichen Element (72) ausgeübt wird, an die erste Stange (13) der Zahnstange (10) befestigt werden kann;
und wobei der Haken (84) des Fahrgestells (74) in den Einrastraum (66) eingesetzt werden kann, der mit der ersten Stange (13) der Zahnstange (10) und mit dem zweiten Befestigungsteil (64) des Einrastgliedes (58) eingesetzt werden kann, um mit dem zweiten Befestigungsteil (64) in Berührung gebracht zu werden, wobei verhindert wird, dass das Fahrgestell (74) beim Installieren an die Zahnstange (10) aus dieser herausgezogen werden kann.

2. Die Zahnstange (10) nach Anspruch 1, wobei der Schlitten (12) weiter ein Rückplättchen (32) umfasst, das an der ersten Schiene (18) befestigt und das Rückplättchen (34) beweglich am Rückplättchen (32) befestigt ist, so dass die erste Halterung (28) der Länge nach am Rückplättchen (32) entlang beweglich ist.

3. Die Zahnstange (10) nach Anspruch 1, wobei der Schlitten (12) weiter eine dritte Schiene (29) umfasst, die gleitbar zwischen der ersten und zweiten Schiene (18, 26) befestigt ist, um einen dreistufigen Schlitten zu bilden.

4. Die Zahnstange (10) nach Anspruch 1, wobei der Schlitten (12) weiter ein Rückplättchen (32) umfasst, das angrenzend am ersten Endteil (20) der ersten Schiene (18) befestigt ist, wobei mit dem Rückplättchen (32) darin ein zweiter Schlittenweg (44) gebildet wird, während das Rückplättchen (34) der ersten Halterung (28) beweglich im zweiten Schlittenweg (44) des Rückplättchens (32) so aufgenommen ist, dass die erste Halterung (28) der Länge nach am Rückplättchen (32) entlang beweglich ist.

5. Die Zahnstange (10) nach Anspruch 1, wobei der mindestens eine vorstehende Teil (50) in eines der Löcher (16) der ersten Stange (13) eingesetzt werden kann.

6. Die Zahnstange (10) nach Anspruch 1, wobei das Einrastglied (58) einen Betätigungsteil (68) umfasst, der am Gehäuseteil (60) befestigt ist, während das Rückplättchen (34) eine Schlitzöffnung (70) aufweist, die mit dem ersten und zweiten Teil (46, 48) begrenzt ist, um den Betätigungsteil (68) des Einrastgliedes (58) bei dessen Betätigung durch die Schlitzöffnung (70) aufzunehmen.

## Revendications

1. Bâti (10) comprenant un ensemble coulissant (12) et un châssis (74) dans lequel l'ensemble coulissant, **caractérisée par le fait qu'**elle comprend:
un premier rail (18) présentant une première extrémité (20) et une seconde extrémité (22) qui est située en correspondance avec la première extrémité (20) ;
un deuxième rail (26) ;
un premier support (28) relié adjacent à la première extrémité (20) du premier rail (18) ; et
un second support (30) relié adjacent à la seconde extrémité (22) du premier rail (18), le premier support (28) inclut :
une plaque de support (34) présentant une première partie (46) et une seconde partie (48), la seconde partie (48) étant courbée et se prolongeant à partir d'une extrémité de la première partie (46) ;
au moins un élément saillant (50) raccordé à la seconde partie (48) de la plaque de support (34) ;
un élément d'engagement (58) raccordé à la plaque de support (34) et présentant une partie de corps (60), une première partie de fixation (62) et une seconde partie de fixation (64), et
un élément à effet ressort (72) pour fournir une force à l'élément d'engagement (58) pour que la première partie de fixation (62) reste positionnée près du ou des éléments saillants (50), **caractérisé en ce que** l'élément d'engagement (58) est raccordé de manière pivotante à la plaque de support (34) et les première et seconde parties de fixation (62, 64) sont essentiellement et perpendiculairement raccordées à une extrémité de la partie de corps (60), la seconde partie de fixation (64) étant courbée et se prolongeant à partir d'une extrémité de la première partie de fixation (62),
**caractérisée par le fait que** l'ensemble coulissant est adapté pour installer le châssis (74) sur le bâti (10), le bâti (10) comporte un premier montant (13) et un second montant (14), les premier et second montants (13, 14) comportent chacun une pluralité d'orifices (16), et le châssis (74) comporte une partie en forme de crochet (84), et
**caractérisée par le fait que** le premier rail (18) définit une première trajectoire de glissement (24) longitudinalement à l'intérieur, et le deuxième rail (26) est coulissant par rapport à la première trajectoire de glissement (24) du premier rail (18) ;
une première extrémité du premier support (28) est relié adjacent à la première extrémité (20) du premier rail (18), une seconde extrémité du premier support (28) est adaptée pour être raccordée au premier montant (13) du bâti (10) ;
une première extrémité du second support (30) est relié adjacent à la seconde extrémité (22) du premier rail (18), une seconde extrémité du second support (30) est adaptée pour être raccordée au second montant (14) du bâti (10) ;
un espace d'engagement (66) est délimité par le premier montant (13) et la seconde partie de fixation (64) lorsque la seconde extrémité du premier support (28) est raccordée au premier montant (13) du bâti (10) ;
la première partie de fixation (62) de l'élément d'engagement (58) est adaptée pour être raccordée au premier montant (13) du bâti (10) par la force fournie par l'élément à effet ressort (72) ;
et **caractérisée par le fait que** la partie en forme de crochet (84) du châssis (74) est adaptée pour être insérée dans l'espace d'engagement (66) délimité par le premier montant (13) du bâti (10) et la seconde partie de fixation (64) de l'élément d'engagement (58) pour s'appuyer contre la seconde partie de fixation (64), moyennant quoi le châssis (74) est empêché d'être retiré du bâti (10) lorsque installé sur le bâti (10).

2. Le bâti (10) selon la revendication 1, l'ensemble coulissant (12) **caractérisée par le fait qu'**elle comprend en outre une plaque arrière (32) fixée au premier rail (18), dans lequel la plaque de support (34) est raccordée de manière mobile à la plaque arrière (32) de sorte que le premier support (28) est longitudinalement mobile le long de la plaque arrière (32).

3. Le bâti (10) selon la revendication 1, l'ensemble coulissant (12) **caractérisée par le fait qu'**elle comprend en outre un troisième rail (29) de manière coulissante entre les premier et deuxième rails (18, 26) pour former un ensemble coulissant en trois étapes.

4. Le bâti (10) selon la revendication 1, l'ensemble coulissant (12) **caractérisée par le fait qu'**elle comprend en outre une plaque arrière (32) fixée adjacent à la première extrémité (20) du premier rail (18), dans lequel la plaque arrière (32) définit une seconde trajectoire de glissement (44) longitudinalement à l'intérieur, et la plaque de support (34) du premier support (28) est reçue de manière mobile par la seconde trajectoire de glissement (44) de la plaque arrière (32) de sorte que le premier support (28) est longitudinalement mobile le long de la plaque arrière (32).

5. Le bâti (10) selon la revendication 1, **caractérisée par le fait que** le ou les éléments saillants (50) sont adaptés pour être insérés dans l'un des orifices (16) du premier montant (13).

6. Le bâti (10) selon la revendication 1, **caractérisée par le fait que** l'élément d'engagement (58) comprend une partie d'actionnement (68) raccordée à la partie de corps (60), et la plaque de support (34) comporte une rainure (70) délimitée par les première et seconde parties (46, 48) de celle-ci de manière à accueillir la partie d'actionnement (68) de l'élément d'engagement (58) par la rainure (70) lorsque la partie d'actionnement (68) est actionnée.
